(19) Europäisches Patentamt
European Patent Office
Office européen des brevets

(11) **EP 2 071 590 B1**

(12) **EUROPEAN PATENT SPECIFICATION**

(45) Date of publication and mention
of the grant of the patent:
**27.11.2013 Bulletin 2013/48**

(51) Int Cl.:
*B21C 3/04* (2006.01)        *H01L 39/24* (2006.01)
*C22C 14/00* (2006.01)       *C22C 27/02* (2006.01)
*C22F 1/00* (2006.01)        *C22F 1/18* (2006.01)
*H01L 39/14* (2006.01)       *B21C 37/04* (2006.01)

(21) Application number: **07828785.1**

(22) Date of filing: **28.09.2007**

(86) International application number:
**PCT/JP2007/069044**

(87) International publication number:
**WO 2008/044500 (17.04.2008 Gazette 2008/16)**

(54) **NbTi SUPERCONDUCTING WIRE ROD**

NBTI-SUPRALEITENDER DRAHTSTAB

TIGE DE FIL MÉTALLIQUE SUPRACONDUCTRICE EN NbTi

(84) Designated Contracting States:
**AT BE BG CH CY CZ DE DK EE ES FI FR GB GR
HU IE IS IT LI LT LU LV MC MT NL PL PT RO SE
SI SK TR**

(30) Priority: **29.09.2006 JP 2006269084**

(43) Date of publication of application:
**17.06.2009 Bulletin 2009/25**

(73) Proprietors:
• **Kabushiki Kaisha Kobe Seiko Sho
Chuo-ku
Kobe-shi
Hyogo 651-8585 (JP)**
• **Japan Superconductor Technology, Inc.
Kobe-shi
Hyogo 6512271 (JP)**

(72) Inventors:
• **MIYATAKE, Takayuki
Nishi-ku, Kobe-shi,
Hyogo 651-2271 (JP)**
• **ZAITSU, Kyoji
Nishi-ku, Kobe-shi,
Hyogo 651-2271 (JP)**
• **MIYAZAKI, Takayoshi
Nishi-ku, Kobe-shi,
Hyogo 651-2271 (JP)**
• **KATO, Hiroyuki
Nishi-ku, Kobe-shi,
Hyogo 651-2271 (JP)**
• **KIZAKI, Satoshi
Nishi-ku, Kobe-shi,
Hyogo 651-2271 (JP)**

(74) Representative: **Gillard, Richard Edward et al
Elkington and Fife LLP
Thavies Inn House
3-4 Holborn Circus
London EC1N 2HA (GB)**

(56) References cited:
EP-A1- 0 525 224        JP-A- 2 010 612
JP-A- 2 112 111         JP-A- 02 112 111
JP-A- 10 154 422        JP-A- 10 154 422
JP-A- 56 001 411        JP-A- 61 201 765
JP-A- 61 201 765        JP-A- 2000 294 053
JP-A- 2000 348 548      JP-A- 2000 348 548
JP-A- 2002 304 924      JP-A- 2002 304 924

**Description**

**TECHNICAL FIELD**

The present invention relates to a NbTi superconducting wire which has a structure in which NbTi alloy filaments are arranged in a Cu matrix, and particularly to a NbTi superconducting wire which has a high critical current density (Jc), high filament uniformity (n value), and thermal and electrical stability and is useful as a material for a superconducting magnet used in an MRI device or an NMR device.

**BACKGROUND ART**

A superconducting magnet used in an MRI device, an NMR device or the like generates a strong magnetic field with the use of zero electrical resistance with the application of a high current in a persistent current mode-operation without using a power source, and is embodied for the first time by using a superconducting phenomenon. In such a persistent current mode-operation, it is necessary to have high magnetic field stability (for example, attenuation rate of magnetic field of 0.01% or less a year).

In order to achieve the high magnetic field stability, it is important to reduce the electrical resistance generated from a wire itself during the persistent current mode-operation. It has been known that the resistance value at this time has a relationship with characteristics of the wire as shown by the following Equation (1) through a  voltage V generated when the operation current of the magnet is applied to the superconducting wire.

$$V = Vc(Jop/Jc)n \qquad (1)$$

Herein, Jop and Jc are a current density of the superconducting wire of the operation current of the magnet and a critical current density of the superconducting wire, respectively, Vc is a reference voltage defining the critical current, and the index is an n value.

The n value is an amount showing the sharpness of the transition from the superconducting state to the normal conduction state, and it is important that the wire has sufficiently high Jc and n value compared with Jop to ensure the high magnetic field stability. Among them, since the n value is exponentially related to the generated voltage of the superconducting wire, the n value is increased in the same manner as in the critical current density Jc of the wire to effectively act on the stability of the magnetic field. When the n value is small, it is necessary to significantly reduce the operation current of the magnet to ensure the high magnetic field stability, so the usage of the wire becomes large, the size of the superconducting magnet is increased, and it is impossible to meet demands for downsizing.

Two types of wires, that is, a NbTi wire and a Nb$_3$Sn wire has been known as representative metal superconducting wires which have been commercially available as a material for the superconducting magnet. Among them, since the NbTi superconducting wire (alloy wire) has a low critical magnetic field (maximum magnetic field capable of maintaining superconductivity) in comparison with the Nb$_3$Sn superconducting wire (compound wire) and can be manufactured at low cost, the NbTi  superconducting wire is used as a material for an outer layer of a magnet for a high magnetic field or a magnet for low and medium magnetic fields.

It has been known that the n value of the NbTi superconducting wire is large when the filament uniformity is excellent. The "filament uniformity" means the uniformity in shape of the wire, and it specifically means that the change in cross-section area of a NbTi alloy filament in a longitudinal direction is small and the change in cross-section area by the location in a cross-section perpendicular to an axis is small (a so-called sausaging phenomenon is small).

Various techniques for the structure of the NbTi superconducting wire have been proposed. For example, JP-A-2002-304924 discloses a technique for ensuring the filament uniformity by setting a diameter of a NbTi alloy filament to 3 to 20 μm, adjusting the copper ratio in the range of 6 to 8 and restricting a region in which the filaments are present in the cross-section area of the wire in the range of 0.3D to 0.9D (D is an outer diameter of the wire) has been proposed.

**DISCLOSURE OF THE INVENTION**

In a NbTi superconducting wire used for a superconducting magnet for MRI or NMR, it is general that a filament diameter is large, specifically, 20 μm or more because it is unnecessary to excite the magnet at high speed, and Cu is generally used for a matrix material because high stability (thermal stability and electrical stability) is required. Particularly, generally, a NbTi superconducting wire used for the generation of low and medium magnetic fields of 7 T (tesla) or less has a copper ratio set to 5.0 or greater.

However, when a NbTi superconducting wire is manufactured only by increasing the copper ratio, abnormal deformation of NbTi alloy filaments easily occurs during, for example, a diameter-reducing process such as extrusion or wire-drawing. Accordingly, a so-called sausaging phenomenon in which a filament diameter is largely changed in a length direction of the superconducting wire occurs, or wire breaking easily occurs on the filaments. When such phenomena occur, a critical current density Jc and an n value of the superconducting wire significantly decrease. That is, regarding a conventional NbTi superconducting wire (particularly, circular wire having circular cross-section perpendicular to axis) having a copper ratio of 5.0 or smaller, a critical current density Jc of about 2700 A/mm$^2$ or more and an n value of about 40 or more are obtained in a magnetic field having a critical current density of 5 T. However, when the copper ratio exceeds 5.0 or more, these characteristics significantly decrease.

Incidentally, in order to apply a superconducting wire as a magnet, it is necessary that the superconducting wire is wound. In such winding, a wire having a substantially rectangular cross-section perpendicular to an axis (hereinafter, referred to as "rectangular wire") can be wound at high surface occupancy and is effective in downsizing of the magnet. For such a rectangular wire, a wire having a circular cross-section is subjected to wire-drawing up to the vicinity of a final wire diameter, and then processed to have a substantially rectangular cross-section by rolling or die wire-drawing and finished. In the processing, the filaments may be flattened or cracking of the filaments may occur in the cross-section of the wire. As a result, superconducting characteristics are deteriorated like the circular wire having a high copper ratio.

According to the studies made by the inventors, it is confirmed that when the circular wire is processed into a rectangular wire, the critical current density Jc and the n value largely change depending on the arrangement state of the filaments. That is, it is necessary to deal with the rectangular wire in a different manner from that for the circular wire. However, considerations in accordance with a cross-section shape for improving the characteristics of the circular wire and the rectangular wire have not been made.

The invention has been made under the above circumstances and an object of the invention is to provide a proper structure for a NbTi superconducting wire which exhibits high filament uniformity (n value) and has a high critical current density Jc even with a high copper ratio, in accordance with the shape of a cross-section perpendicular to an axis.

That is, the invention relates to the following (1) to (5).

(1) A NbTi superconducting wire which comprises a Cu matrix and a plurality of NbTi alloy filaments disposed in the Cu matrix, said NbTi superconducting wire having a substantially circular cross-section perpendicular to an axis thereof, wherein a ratio of the cross-section area of the Cu matrix to the total cross-section area of said NbTi alloy filaments (cross-section area of Cu matrix/total cross-section area of NbTi alloy filaments) is equal to or greater than 5.0 and smaller than 15.0,
wherein said NbTi alloy filaments have an average diameter d of 30 to 200 μm, and
wherein the ratio (S/d) of an average interval S between said NbTi alloy filaments to the average diameter d of said NbTi alloy filaments is in the range of 0.10 to 0.40.
(2) The NbTi superconducting wire according to (1) above,
wherein when an outer diameter of said superconducting wire is D, said NbTi alloy filaments are not disposed up to a position equivalent to 0.15D in a radial direction from an outer surface.
(3) A NbTi superconducting wire which comprises a Cu matrix and a plurality of NbTi alloy filaments disposed in the Cu matrix, said NbTi superconducting wire having a substantially rectangular cross-section perpendicular to an axis thereof,
wherein a ratio of the cross-section area of the Cu matrix to the total cross-section area of said NbTi alloy filaments (cross-section area of Cu matrix/total cross-section area of NbTi alloy filaments) is equal to or greater than 5.0 and smaller than 15.0,
wherein said NbTi alloy filaments have an average diameter d of 30 to 200 μm, and
wherein the ratio (S/d) of an average interval S between said NbTi alloy filaments to the average diameter d of said NbTi alloy filaments is in the range of 0.10 to 0.40.
(4) The NbTi superconducting wire according to (3) above,
wherein when a length of a short side of the cross-section of said superconducting wire perpendicular to the axis thereof is H and a length of a long side of the cross-section of said superconducting wire perpendicular to the axis thereof is W, said NbTi alloy filaments are not disposed up to a position equivalent to 0.10H and 0.15W in a depth direction from an outer surface.
(5) The NbTi superconducting wire according to (3) or (4) above,
wherein a ratio (W/H) of a length W of a long side of the cross-section of said superconducting wire perpendicular to the axis thereof to a length H of a short side of the cross-section of said superconducting wire perpendicular to the axis thereof is in the range of 1.2 to 2.0.

According to the invention, by properly setting a diameter of a NbTi alloy filament of a NbTi superconducting wire as well as properly setting the relationship between the diameter of the filament and a filament interval, and if necessary, by properly controlling a region in which filaments are present in accordance with the difference in cross-section shape, the NbTi superconducting wire which can exhibit high filament uniformity (n value) and has a high critical current density Jc even with a copper ratio of 5.0 or greater can be obtained. Such a NbTi superconducting wire is very useful as a material for a superconducting magnet used in an MRI device or an NMR device.

## BRIEF DESCRIPTION OF THE DRAWINGS

Fig. 1 is a diagram schematically showing the displacement of a circular wire.
Fig. 2 is a diagram schematically showing the cross-section structure of a rectangular wire.
Fig. 3 is a diagram schematically showing the basic cross-section structure of a NbTi superconducting wire (circular wire).

Description of Reference Numerals and Signs

1: Cu matrix
2: NbTi alloy filament

## BEST MODE FOR CARRYING OUT THE INVENTION

In accordance with a complex processing theory, it has been well known that when a NbTi superconducting wire having the same cross-section structure employs a structure in which a material having deformation resistance larger than that of Cu (material having deformation resistance closer to that of NbTi) is disposed around NbTi filaments or a group of filaments formed of an assembly of filaments, abnormal deformation of the filaments is significantly improved and thus it is possible to obtain sound filaments even with a filament diameter of a several-micron order. That is, fine filaments can be obtained by reducing the difference in deformation resistance between NbTi and a matrix material. In accordance with the theory, it is expected that when a copper ratio is increased, the difference in deformation resistance increases and thus nonuniform deformation easily occurs.

Based on the above information, the inventors have inspected the structure of a wire for achieving the above object from various angles. As a result, they have found that a NbTi superconducting wire suitable for the object even with a high copper ratio can be obtained by properly setting a NbTi alloy filament diameter (average diameter) and properly setting the relationship between the average NbTi alloy filament diameter and a filament interval, regardless of a shape of the cross-section of the wire, thereby accomplishing the invention.

Regarding a superconducting wire of the invention, the reasons a copper ratio, a NbTi alloy filament diameter, and the relationship between the NbTi alloy filament diameter and a filament interval are restricted are as follows.

Copper Ratio: Equal to or Greater Than 5.0 and Less Than 15.0

In the past, it has been said that characteristics of the superconducting wire are deteriorated when the copper ratio is 5.0 or greater. However, since the present invention aims at improving the characteristics of a superconducting wire having a copper ratio of 5.0 or greater, it assumes that the copper ratio is 5.0 or greater. However, when the copper ratio of the superconducting wire is 15.0 or greater, the problem described above does not occur because complex processing by extrusion, wire-drawing or the like becomes unnecessary and a composite wire can be realized by ensuring the adhesion, for example, by putting a wire having a small copper ratio (about 1.0) in a sleeve made of Cu or a concave groove and pressure-bonding or soldering them.

Accordingly, in the NbTi superconducting wire of the invention, the ratio of the cross-section area of a Cu matrix to the total cross-section area of NbTi alloy filaments (cross-section area of Cu matrix/total cross-section area of NbTi alloy filaments) is restricted to be equal to or greater than 5.0 and smaller than 15.0.

Average Diameter d of NbTi Alloy Filaments: 30 to 200 $\mu$m

When an average diameter d of the NbTi alloy filaments is less than 30 $\mu$m, a CuTi compound is easily precipitated at the interface between Cu as a base material and the NbTi alloy filament during a heat treatment (to be described later) in a process of manufacturing the NbTi alloy superconducting wire. Such a compound is hard and causes the occurrence of sausaging in wire-drawing of a composite wire formed of Cu and NbTi alloy filaments, so that a critical current density Jc and an n value decrease. From the viewpoint that the CuTi compound grows up to about 15 $\mu$m in size in accordance with manufacturing conditions, a preferable lower limit of the average diameter of the NbTi alloy filaments is 50 $\mu$m.

On the other hand, when the average diameter of the NbTi alloy filaments is more than 200 $\mu$m, a so-called "magnetic flux jump" causes a phenomenon in which a magnet is quenched. That is, it has been known that when a current is applied to the magnet, disturbance and the like such as the movement of the wire are caused and a phenomenon in which the magnetic flux in the wire flies thus occurs and, when the filament diameter is large, a specific surface area in which heat is circumferentially diffused is smaller than in the case of a thin filament, so that the heat is stored in the wire and the quenching is performed. From the viewpoint of the realization of practical exitation time for magnet, a preferable upper limit of the average diameter of the NbTi alloy filaments is 100 $\mu$m.

In the invention, the NbTi alloy filament diameter is set as an average diameter and this means that even if there is some change in wire diameter in the wire, it is sufficient if the NbTi alloy filament diameter is set in the above range when the changes in diameter are averaged. However, it is a given fact that, it is not like that variation is permitted in NbTi alloy filament diameter when the NbTi alloy filament diameter is set in the above range, and the NbTi alloy filaments are formed as uniformly as possible (same diameter).

Ratio (S/d) of Average Interval S Between NbTi Alloy Filaments to Average Diameter d of NbTi Alloy Filaments: 0.10 to 0.40

When the above ratio (S/d) is smaller than 0.10, in manufacturing a single-filamentary wire as a material for a multi-filamentary wire (see the manufacturing procedure to be described later), the Cu layer disposed around a NbTi alloy filament becomes too thin and thus processing problems such as cracking and wire breaking occur in the Cu layer. On the other hand, when the ratio (S/d) is greater than 0.40, the ratio of the Cu part (Cu matrix) around the matrix to the diameter of the filament becomes too large and thus the arrangement state of the filament becomes improper. As a result, the critical current density Jc and the n value significantly decrease. A preferable lower limit of the ratio (S/d) is 0.20 and a preferable upper limit thereof is 0.30, respectively. The interval between NbTi alloy filaments is set as an "average interval S", and this is achieved for the same reason as the NbTi alloy filament diameter set as the "average diameter d".

The above-described requirements are applied to both a circular wire and a rectangular wire. In order to improve the characteristics of the NbTi superconducting wire, it is also preferable that the region in which the NbTi alloy filaments are present is controlled in a proper manner. However, it is necessary to deal with the region in which the filaments are present in accordance with the respective shapes of the circular wire and the rectangular wire. Herein, in this description, the circular wire has a substantially circular cross-section shape and the substantially circular shape includes, for example, a circular shape, an elliptical shape and the like. The rectangular wire has a substantially rectangular cross-section shape and the substantially rectangular shape includes, for example, a rectangular shape with rounded corners.

In the circular wire, in order to realize a higher critical current density Jc and a higher n value by maintaining the filament uniformity upon wire-drawing, when an outer diameter of the superconducting wire is D, it is preferable that the NbTi alloy filaments are not present up to a position equivalent to 0.15D in a radial direction from an outer surface. That is, the region in which the NbTi alloy filaments are present is a region on the inner side of the position equivalent to 0.15D in a radial direction from an outer surface. The NbTi alloy filaments may be present at the center of the wire, but from the viewpoint of setting a proper distance between the filaments, a region in which the NbTi alloy filaments are not present may be formed. However, it is preferable that such a region is equivalent to up to 0.6D (D is the outer diameter of the wire) in a radial direction from the center from the viewpoint of maintaining the filament diameter in a predetermined range and setting the copper ratio in a proper range.

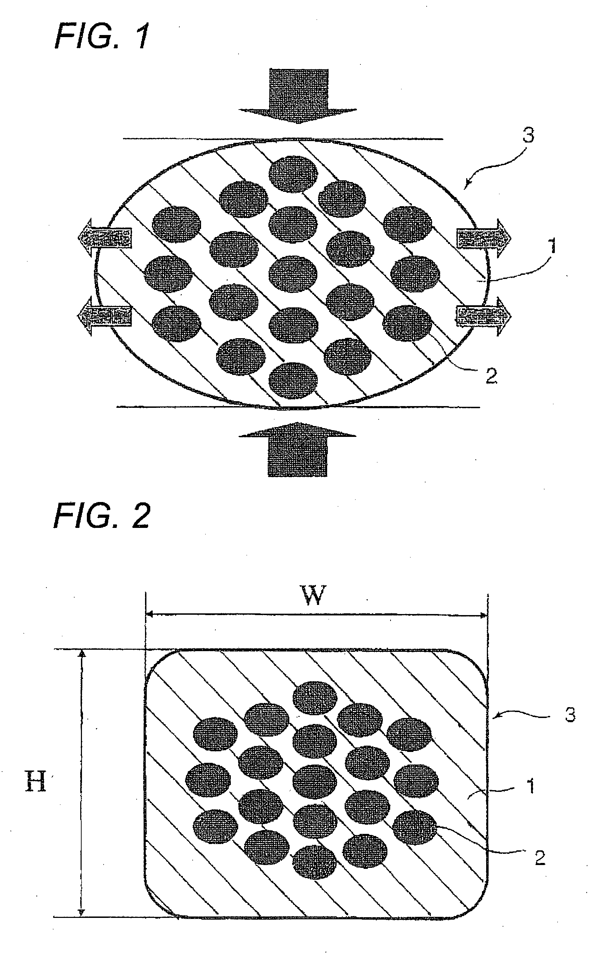

On the other hand, as described above, the rectangular wire is processed to have a substantially rectangular cross-section in a final stage of the wire-drawing. However, even when the NbTi alloy filaments are properly present in a stage of a circular wire, the filaments may be displaced out of the proper region when being processed into the rectangular wire, whereby the critical current density Jc and the n value may decrease. Particularly, the rectangular wire is largely affected when the NbTi alloy filaments are present at the outer circumstance, and thus a bad effect is caused on each characteristic. That is, during the processing into a shape having a substantially rectangular cross-section, the filaments are restricted in movement in a vertical direction (short side direction) and thus they are little displaced. However, in a width direction (long side direction), the filaments are displaced in a direction escaping to the outside, and at this time, cracking or nonuniform deformation occurs in the wire. Such a displacement in the circular wire is shown in Fig. 1 (in Fig. 1, 1 is a Cu matrix, 2 is a NbTi alloy filament, and 3 is a NbTi superconducting wire).

Due to these reasons, the rectangular wire preferably employs a structure in which, in the short side, when a length of the short side is H, the NbTi alloy filaments are not present up to a position equivalent to 0.10H in a depth direction from an outer surface, and in the long side, in a final stage in which processing into a rectangular shape is performed (at most), when a length of the long side is W, the NbTi alloy filaments are not present up to a position equivalent to 0.15W in a depth direction from an outer surface. In the processing into the rectangular wire, although the NbTi alloy filaments in the wire are slightly deformed, the restricted range of the average diameter d of the NbTi alloy filaments is the same in both the cases of the circular wire and the rectangular wire.

In order to exhibit an effect by regulating the above-described preferable requirements, it is preferable that a ratio (W/H) of the length of the long side W to the length of the short side H of the rectangular wire is set in the proper range. When a value of the ratio (W/H) is less than 1.2, the above-mentioned disadvantages in the case of the rectangular wire are not so notably shown. When a value of the ratio (W/H) is more than 2.0, the wire becomes too flat, so that even when the region in which the filaments are present is restricted as described above, an effect thereof is not easily exhibited. For these reasons, it is preferable that the ratio (W/H) of the length of the long side W to the length of the short side H of the rectangular wire be in the range of 1.2 to 2.0. The cross-section structure of the rectangular wire is schematically shown in Fig. 2.

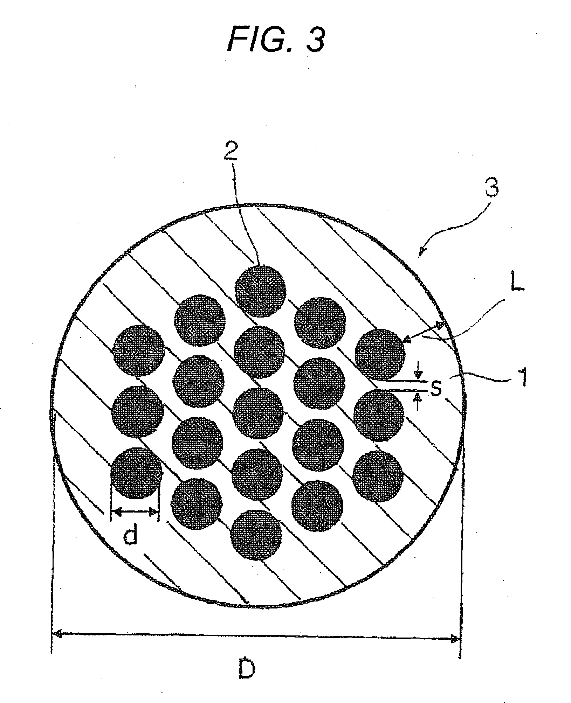

Fig. 3 is a diagram schematically showing the basic cross-section structure of the NbTi superconducting wire (circular wire). As shown in Fig. 3, in the NbTi superconducting wire 3, a plurality of NbTi alloy filaments 2 are arranged in a Cu matrix 1 so as not to be brought into contact with each other. In Fig. 3, for convenience of explanation, the number of the NbTi alloy filaments 2 is 19, but actually, several tens to several hundreds of the NbTi alloy filaments are disposed in general.

In the NbTi superconducting wire of the invention, the above effect can be exhibited by properly restricting the cross-section ratio of the Cu matrix 1 to the NbTi alloy filaments 2 (copper ratio), the diameter (average diameter) d of the NbTi alloy filaments and the ratio (S/d) of the interval S between the NbTi alloy filaments to the average diameter d. In addition, according to the necessary, the region in which the NbTi alloy filaments are present is set to be not more than 0.85D (in Fig. 3, the region in which no NbTi alloy filament is present, which is represented by L, is not less than 0.15D). Such a state is the same as in the case of the rectangular wire except for the cross-section shape and the preferable region in which the filaments are present.

Basically, manufacturing the above-described NbTi superconducting wire is performed in accordance with the following procedure. First, a NbTi alloy bar is inserted into a Cu pipe and then subjected to a surface-reducing process such as extrusion or wire-drawing to provide a single-filamentary material in which a NbTi alloy filament is embedded in a base material made of Cu (in general, a cross-section is formed in a hexagonal shape). The single-filamentary material is cut into a proper length and the plural cut single-filamentary material pieces are tied together and combined. They are then inserted into a Cu pipe to make a pipe-shaped composite wire (multi-filamentary wire). When such a composite wire is made, a Cu wire (Cu spacer), which has the same cross-section shape as that of the single-filamentary wire by subjecting a Cu bar into which no NbTi alloy filament is inserted to wire-drawing, is disposed at a predetermined position in the cross-section of the composite wire to control the region in which no NbTi alloy filament is present. Further, by the Cu spacer and the Cu pipe (Cu pipe for manufacturing the single-filamentary wire and the multi-filamentary wire), the Cu matrix 1 (Fig. 3) of the superconducting wire is formed. Furthermore, by changing a thickness of the Cu pipe (thickness of the Cu layer) of the single-filamentary wire, the distance between the NbTi filaments when the multi-filamentary wire is made is adjusted.

The composite wire obtained in this manner is subjected to wire-drawing to obtain a NbTi superconducting wire. If necessary, an aging heat treatment (about 380 to 430°C) for precipitating $\alpha$-Ti and thereby increasing a critical current density is performed during the wire-drawing. The same manufacturing procedure as above is also applied to the case of the rectangular wire, except that finally, the cross-section is formed in a substantially rectangular shape.

The NbTi superconducting wire of the invention has the basic structure in which the NbTi alloy filaments are arranged in the Cu matrix, and in general, a material in which about 45 to 50 mass% of Ti is included in Nb is employed as an alloy material used in the NbTi alloy filaments. However, if necessary, the material may include a small amount of elements such as Ta and Hf (about 5 mass% or less).

Hereinafter, the invention will be described in more detail with reference to the examples. The invention is not essentially limited to the following examples, and proper changes can be applied thereto without departing from the spirit described above and later to realize the invention and are included in the technical scope of the invention.

Examples

Example 1

A Nb-47 mass% Ti bar (diameter: 100 mm) was inserted into a pipe made of Cu (outer diameter: 125 mm, inner diameter: 100 mm) and then both ends of the pipe were sealed to manufacture an extrusion billet formed of a composite material of Cu/Nb-Ti. The extrusion billet was subjected to extrusion and then subjected to wire-drawing to manufacture a Cu/NbTi composite wire having a hexagonal cross-section shape.

Next, a hexagonal Cu material (Cu spacer) processed to have the same cross-section shape as that of the hexagonal single-filamentary wire was combined so that the arrangement of the hexagonal single-filamentary wire was symmetrical, and then inserted into a Cu pipe (outer diameter: 50 to 40 mm, inner diameter: 43 to 35 mm), It was subjected to wire-drawing at various processing rates to manufacture a multi-filamentary NbTi superconducting wire (diameter: 1.0 mm) having various copper ratios.

During the manufacturing process, a heat treatment (aging heat treatment) at 400°C for 60 hours was performed three times. A critical current density Jc and an n value of the obtained NbTi superconducting wire were measured under the following conditions.

(Measurement of Critical Current Density Jc)

A current was applied to a sample (superconducting wire) under an external magnetic field of 5 T (tesla) in liquid helium (temperature 4.2 K) and a generated voltage was measured in accordance with a four-terminal method. A current value (critical current Ic) at which an electrical field of 0.1 $\mu$V/cm was generated was measured and the current value was divided by a cross-section area per a non-Cu part in the wire to obtain the critical current density Jc.

(Measurement of n Value)

In a curve (Jc-V) obtained by the same measurement as that for obtaining the critical current density Jc, data between 0.1 (V/cm and 1.0 (V was displayed in a double logarithm. As an inclination thereof, the n value was obtained (see the above Equation (1)).

The measurement results are shown in the following Table 1 together with various characteristics (copper ratio, the number of the filaments, average filament diameter d, region in which the filaments are present, S/d and the like) of the NbTi superconducting wires. The region in which the filaments are present shows the innermost position (innermost layer) and the outermost position (outermost layer) of the region in which the filaments are arranged with reference to a wire diameter D. For example, "outermost layer: 0.85D" means that the outermost position of the NbTi alloy filaments is a position of 0.85D (that is, no NbTi alloy filament is present up to 0.15D in a radial direction from an outer surface). Additionally, "0.0D" of the innermost layer means that the NbTi alloy filaments are also present at the center of the wire (the same as in the rectangular wire of Example 2).

Table 1

| Test No. | Copper Ratio | Number of Filaments | Filament Diameter ($\mu$m) | Region in Which Filaments are Present | | S/d | Critical Current Density Jc (A/mm$^2$) | n Value | Note |
| --- | --- | --- | --- | --- | --- | --- | --- | --- | --- |
| | | | | Innermost Layer | Outermost Layer | | | | |
| 1 | 3.5 | 42 | 78 | 0.2D | 0.8D | 0.5 | 2700 | 62 | Small Cu ratio |
| 2 | 5.5 | 30 | 81 | 0.2D | 0.9D | 0.5 | 2300 | 35 | Large S/d |
| 3 | 9.9 | 55 | 41 | 0.0D | 0.5D | 0.25 | 2940 | 72 | Example |
| 4 | 5.5 | 30 | 81 | 0.0D | 0.7D | 0.35 | 2750 | 63 | Example |
| 5 | 7.5 | 24 | 82 | 0.7D | 0.9D | 0.5 | 2100 | 36 | Out of Region in Which Filaments are Present |
| 6 | 7.1 | 24 | 82 | 0.2D | 0.6D | 0.25 | 2800 | 67 | Example |
| 7 | 9.9 | 18 | 71 | 0.1D | 0.5D | 0.25 | 2850 | 61 | Example |
| 8 | 6.8 | 24 | 82 | 0.2D | 0.5D | 0.08 | Evaluation cannot be made Due to Wire Breaking | | Small S/d |

From the results, the following consideration can be made. First, a sample of Test No. 1 is an example having a relatively low copper ratio, and even when a region in which filaments are present is close to an outer surface and a ratio S/d is a large value, the sample has relatively excellent superconducting characteristics. Samples of Test No. 2 and No. 5 have a copper ratio of 5.5, but a region in which filaments are present or a ratio S/d are out of the proper ranges. Accordingly, the samples have deteriorated superconducting characteristics. In addition, in the case of a sample of Test No. 8, a ratio S/d is set to a very small value, but wire breaking occurs during multi-filamentary wire drawing. Accordingly, it is evaluated that the sample does not have superconducting characteristics.

On the other hand, samples of Test No. 3, Test No. 4, Test No. 6 and Test No. 7 are examples satisfying the requirements specified in the invention and it is found that NbTi superconducting wires exhibiting excellent superconducting characteristics are obtained.

Example 2

A part (samples of Test No. 4, Test No. 5 and Test No. 6) of the circular wires manufactured in the first example was used to be processed into rectangular wires (length of short side H: 0.78 mm, length of long side W: 1.16 mm) of which the ratio (W/H) of the vicinity of the final wire diameter was 1.5. At this time, by adjusting a rolling-reduction ratio of the rolling during the processing into a rectangular shape, NbTi superconducting wires, each of which had a different region in which filaments are present, were manufactured. Under the same conditions as in the first example, a critical current density Jc and an n value of the obtained NbTi superconducting wires were measured.

The measurement results of the critical current density and the n value are shown in the following Table 2 together with various characteristics (copper ratio, the number of filaments, average filament diameter d, region in which the filaments are present, S/d and the like) of the NbTi superconducting wire.

Table 2

| Test No. | Copper Ratio | Region in Which Filaments are Present (H Direction) | | Region in Which Filaments are Present (W Direction) | | S/d | Critical Current Density Jc (A/mm$^2$) | n Value | Note |
|---|---|---|---|---|---|---|---|---|---|
| | | Innermost Layer | Outermost Layer | Innermost Layer | Outermost Layer | | | | |
| 9 | 5.5 | 0.0H | 0.75H | 0.0W | 0.7W | 0.35 | 2860 | 60 | Example |
| 10 | 5.5 | 0.0H | 0.85H | 0.0w | 0.7W | 0.35 | 2710 | 55 | Example |
| 11 | 7.1 | 0.25H | 0.7H | 0.2W | 0.6W | 0.25 | 2810 | 57 | Example |
| 12 | 7.1 | 0.25H | 0.8H | 0.2W | 0.6W | 0.25 | 2720 | 54 | Example |
| 13 | 7.5 | 0.75H | 0.95H | 0.65W | 0.85W | 0.5 | 2040 | 28 | Large S/d |
| 14 | 5.5 | 0.0H | 0.95H | 0.65W | 0.85W | 0.35 | 2650 | 45 | Example |

From the results, the following consideration can be made. Since a sample of Test No. 13 had a ratio S/d out of the proper range, the critical current density Jc and the n value were low.

On the other hand, samples of Test Nos. 9 to 12 and Test No. 14 are examples satisfying the requirements specified in the invention and it is found that NbTi superconducting wires exhibiting excellent superconducting characteristics are obtained.

While the present invention has been described in detail and with reference to specific embodiments thereof, it will be apparent to one skilled in the art that various changes and modifications can be made therein without departing from the scope thereof.

This application is based on Japanese patent application No. 2006-269084 filed September 29, 2006, the entire contents thereof being hereby incorporated by reference.

**INDUSTRIAL APPLICABILITY**

According to the invention, by properly setting a diameter of a NbTi alloy filament of a NbTi superconducting wire and properly setting the relationship between the NbTi alloy filament diameter and a filament interval, and if necessary, by properly controlling a region in which filaments are present in accordance with the difference in cross-section shape, a NbTi superconducting wire which can exhibit high filament uniformity (n value) and has a high critical current density Jc even with a copper ratio of 5.0 or greater can be obtained. Such a NbTi superconducting wire is very useful as a material for a superconducting magnet used in an MRI device or an NMR device.

**Claims**

1. A NbTi superconducting wire which comprises a Cu matrix and a plurality of NbTi alloy filaments disposed in the Cu matrix, said NbTi superconducting wire having a circular cross-section perpendicular to an axis thereof,
   wherein a ratio of the cross-section area of the Cu matrix to the total cross-section area of said NbTi alloy filaments (cross-section area of Cu matrix/total cross-section area of NbTi alloy filaments) is equal to or greater than 5.0 and smaller than 15.0,
   wherein said NbTi alloy filaments have an average diameter d of 30 to 200 $\mu$m, and
   wherein the ratio (S/d) of an average interval S between said NbTi alloy filaments to the average diameter d of said NbTi alloy filaments is in the range of 0.10 to 0.40.

2. The NbTi superconducting wire according to Claim 1,
   wherein when an outer diameter of said superconducting wire is D, said NbTi alloy filaments are not disposed up to a position equivalent to 0.15D in a radial direction from an outer surface.

3. A NbTi superconducting wire which comprises a Cu matrix and a plurality of NbTi alloy filaments disposed in the Cu matrix, said NbTi superconducting wire having a rectangular cross-section perpendicular to an axis thereof,
   wherein a ratio of the cross-section area of the Cu matrix to the total cross-section area of said NbTi alloy filaments (cross-section area of Cu matrix/total cross-section area of NbTi alloy filaments) is equal to or greater than 5.0 and smaller than 15.0,
   wherein said NbTi alloy filaments have an average diameter d of 30 to 200 $\mu$m, and
   wherein the ratio (S/d) of an average interval S between said NbTi alloy filaments to the average diameter d of said NbTi alloy filaments is in the range of 0.10 to 0.40.

4. The NbTi superconducting wire according to Claim 3,
   wherein when a length of a short side of the cross-section of said superconducting wire perpendicular to the axis thereof is H and a length of a long side of the cross-section of said superconducting wire perpendicular to the axis thereof is W, said NbTi alloy filaments are not disposed up to a position equivalent to 0.10H and 0.15W in a depth direction from an outer surface.

5. The NbTi superconducting wire according to Claim 3 or 4,
   wherein a ratio (W/H) of a length W of a long side of the cross-section of said superconducting wire perpendicular to the axis thereof to a length H of a short side of the cross-section of said superconducting wire perpendicular to the axis thereof is in the range of 1.2 to 2.0.


**Patentansprüche**

1. NbTi-Supraleiterdraht, der eine Cu-Matrix und eine Vielzahl an NbTi-Legierungsfilamenten, die in der Cu-Matrix angeordnet sind, umfasst, wobei der genannte NbTi-Supraleiterdraht einen kreisförmigen Querschnitt senkrecht zu einer Achse davon aufweist,
   worin ein Verhältnis der Querschnittsfläche der Cu-Matrix zur gesamten Querschittsfläche der genannten NbTi-Legierungsfilamente (Querschnittsfläche von Cu-Matrix/gesamte Querschnittsfläche der NbTi-Legierungsfilamente) gleich oder größer als 5,0 und kleiner als 15,0 ist,
   worin die genannten NbTi-Legierungsfilamente einen durchschnittlichen Durchmesser d von 30 bis 200 $\mu$m aufweisen
   und
   worin das Verhältnis (S/d) von einem durchschnittlichen Abstand S zwischen den genannten NbTi-Legierungsfilamenten zu dem durchschnittlichen Durchmesser d der genannten NbTi-Legierungsfilamente im Bereich von 0,10 bis 0,40 liegt.

2. NbTi-Supraleiterdraht nach Anspruch 1,
   worin, wenn ein Außendurchmesser des genannten Supraleiterdrahts D ist, die genannten NbTi-Legierungsfilamente nicht bis zu einer Position angeordnet sind, die 0,15D in einer radialen Richtung von einer Außenoberfläche entspricht.

3. NbTi-Supraleiterdraht, der eine Cu-Matrix und eine Vielzahl an NbTi-Legierungsfilamenten, die in der Cu-Matrix angeordnet sind, umfasst, wobei der genannte NbTi-Supraleiterdraht einen rechteckigen Querschnitt senkrecht zu einer Achse davon aufweist,
worin ein Verhältnis der Querschnittsfläche der Cu-Matrix zur gesamten Querschittsfläche der genannten NbTi-Legierungsfilamente (Querschnittsfläche von Cu-Matrix/gesamte Querschnittsfläche der NbTi-Legierungsfilamente) gleich oder größer als 5,0 und kleiner als 15,0 ist,
worin die genannten NbTi-Legierungsfilamente einen durchschnittlichen Durchmesser d von 30 bis 200 $\mu$m aufweisen
und
worin das Verhältnis (S/d) von einem durchschnittlichen Abstand S zwischen den genannten NbTi-Legierungsfilamenten zu dem durchschnittlichen Durchmesser d der genannten NbTi-Legierungsfilamente im Bereich von 0,10 bis 0,40 liegt.

4. NbTi-Supraleiterdraht nach Anspruch 3,
worin, wenn eine Länge einer kurzen Seite des Querschnitts des genannten Supraleiterdrahts senkrecht zur Achse davon H ist und die Länge einer langen Seite des Querschnitts des genannten Supraleiterdrahts senkrecht zur Achse davon W ist, die genannten NbTi-Legierungsfilamente nicht bis zu einer Position angeordnet sind, die 0,10H und 0,15W in einer Tiefenrichtung von einer Außenoberfläche entspricht.

5. NbTi-Supraleiterdraht nach Anspruch 3 oder 4,
worin ein Verhältnis (W/H) von einer Länge W einer langen Seite des Querschnitts des genannten Supraleiterdrahts senkrecht zur Achse davon zu einer Länge H einer kurzen Seite des Querschnitts des genannten Supraleiterdrahts senkrecht zur Achse davon im Bereich von 1,2 bis 2,0 liegt.

## Revendications

1. Fil supraconducteur en NbTi qui comprend une matrice en Cu et une pluralité de filaments en alliage de NbTi disposés dans la matrice en Cu, ledit fil supraconducteur en NbTi ayant une section transversale circulaire perpendiculaire à un axe de celui-ci,
dans lequel un rapport de la surface en section transversale de la matrice en Cu sur la surface en section transversale totale desdits filaments en alliage de NbTi (surface en section transversale de la matrice en Cu / surface en section transversale totale des filaments en alliage de NbTi) est égal ou supérieur à 5,0 et inférieur à 15,0,
dans lequel lesdits filaments en alliage de NbTi ont un diamètre moyen d de 30 à 200 $\mu$m, et
dans lequel le rapport (S/d) d'un intervalle moyen S entre lesdits filaments en alliage de NbTi sur le diamètre moyen d desdits filaments en alliage de NbTi est dans la gamme de 0,10 à 0,40.

2. Fil supraconducteur en NbTi selon la revendication 1, dans lequel quand un diamètre extérieur dudit fil supraconducteur est D, lesdits filaments en alliage de NbTi ne sont pas disposés jusqu'à une position équivalente à 0,15 D dans une direction radiale depuis une surface extérieure.

3. Fil supraconducteur en NbTi qui comprend une matrice en Cu et une pluralité de filaments en alliage de NbTi disposés dans la matrice en Cu, ledit fil supraconducteur en NbTi ayant une section transversale rectangulaire perpendiculaire à un axe de celui-ci,
dans lequel un rapport de la surface en section transversale de la matrice en Cu sur la surface en section transversale totale desdits filaments en alliage de NbTi (surface en section transversale de la matrice en Cu / surface en section transversale totale des filaments en alliage de NbTi) est égal ou supérieur à 5,0 et inférieur à 15,0,
dans lequel lesdits filaments en alliage de NbTi ont un diamètre moyen d de 30 à 200 $\mu$m, et
dans lequel le rapport (S/d) d'un intervalle moyen S entre lesdits filaments en alliage de NbTi sur le diamètre moyen d desdits filaments en alliage de NbTi est dans la gamme de 0,10 à 0,40.

4. Fil supraconducteur en NbTi selon la revendication 3, dans lequel quand une longueur d'un côté court de la section transversale dudit fil supraconducteur perpendiculaire à l'axe de celui-ci est H et qu'une longueur d'un côté long de la section transversale dudit fil supraconducteur perpendiculaire à l'axe de celui-ci est W, lesdits filaments en alliage de NbTi ne sont pas disposés jusqu'à une position équivalente à 0,10 H et 0,15 W dans une direction en profondeur depuis une surface extérieure.

5. Fil supraconducteur en NbTi selon la revendication 3 ou la revendication 4,
dans lequel un rapport (W/H) d'une longueur W d'un côté long de la section transversale dudit fil supraconducteur perpendiculaire à l'axe de celui-ci sur une longueur H d'un côté court de la section transversale dudit fil supraconducteur perpendiculaire à l'axe de celui-ci est dans la gamme de 1,2 à 2,0.

*FIG. 1*

*FIG. 2*

# FIG. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002304924 A

- JP 2006269084 A